# EUROPEAN PATENT APPLICATION

(11) **EP 4 546 423 A2**
(43) Date of publication of application: **30.04.2025**
(21) Application number: 24197714.9
(22) Date of filing: 30.08.2024
(51) Int. Cl.: H01L 25/11, H01L 23/31, H01L 23/495, H01L 23/64, H01L 25/065, H10D 1/20, H01L 25/10, H01L 25/16

(54) **PACKAGE CONFIGURATION FOR HIGH VOLTAGE GATE DRIVERS WITH A TRANSFORMER**

(30) Priority: 26.10.2023 US 202318495060
(71) Applicant: Allegro MicroSystems, LLC, Manchester, NH 03103 (US)
(72) Inventor: Mangtani, Vijay, Nashua, NH 03062 (US); David, Paul A., Bow, NH 03304 (US); Taylor, William P., Amherst, NH 03031 (US); Wong, Harianto, Southborough, MA 01772 (US); Healey, Natasha, Bedford, NH 03110 (US); Chandra, Harry, Phoenix, AZ 85044 (US)
(74) Representative: South, Nicholas Geoffrey

(57) **Abstract**

According to one aspect of the present disclosure, a voltage isolated integrated circuit (IC) package configuration includes a first package comprising a transformer and a mold material enclosing the transformer to form a first package body, wherein the first package comprises a first lead set to permit electrical connection to the transformer. In some embodiments, a second package comprising a lead frame, two or more semiconductor die supported by the lead frame, and a mold material enclosing the two or more semiconductor die to form a second package body, wherein the lead frame comprises a second lead set to permit electrical connection to the two or more semiconductor die. In some embodiments, the one or more leads of the first lead set is directly electrically connected to one or more leads of the second lead set, wherein the first package and the second package are mechanically coupled together.

## Description

### BACKGROUND

Voltage isolation can be used for electronic packages having circuit components with two separate voltage levels connected to the electrical connections of the package. Galvanic isolation typically includes electrical isolation coupled with lack of direct electrical contact between the circuit components. Such galvanic isolation can be used to separate circuits in order to protect users from coming into direct contact with hazardous voltages. Galvanic isolation may also be used to simplify circuit design, reduce cost or improve system performance. Magnetic coupling typically relies on use of a transformer to couple, yet galvanically separate, circuits on the different sides of the transformer, typically referred to as the primary and secondary sides.

Integrated circuit (IC) packaging techniques can be used for isolated voltage circuits like ones utilizing magnetic coupling. The packaging techniques may be used to integrate one or more semiconductor dies into a module or package, for example by encapsulating the die with a non-conductive, insulating mold material.

The term "clearance" refers to the shortest distance through air between two conductive parts, such as the primary and secondary leads. The term "creepage" refers to the shortest distance between two conductive parts along the surface of any insulation material common to both parts. The spacing distance between components that are required to withstand a given working voltage (i.e., the highest voltage level that insulation under consideration can be subjected to when a device is operating under normal use) is specified in terms of creepage and clearance. Meeting specified creepage and clearance requirements can become challenging, particularly as package dimensions are reduced.

### SUMMARY

According to one aspect of the present disclosure, a voltage isolated integrated circuit (IC) package configuration. In some embodiments, the IC package configuration also includes a first package comprising a transformer and a mold material enclosing the transformer to form a first package body. In some embodiments, the IC package configuration also includes a first package comprising a first lead set to permit electrical connection to the transformer. In some embodiments, the IC package configuration also includes a second package comprising a lead frame, two or more semiconductor die supported by the lead frame, and a mold material enclosing the two or more semiconductor die to form a second package body. In some embodiments, the IC package configuration also includes a lead frame comprising a second lead set to permit electrical connection to the two or more semiconductor die. In some embodiments, the IC package configuration also includes one or more leads of the first lead set directly electrically connected to one or more leads of the second lead set, wherein the first package and the second package are mechanically coupled together.

According to one aspect of the present disclosure, a voltage isolated integrated circuit (IC) package configuration. In some embodiments, the IC package configuration also includes a second package body that has a top surface and a bottom surface, wherein the second lead set comprises preformed pillars that extend from the bottom surface to the top surface of the second package body.

According to one aspect of the present disclosure, a voltage isolated integrated circuit (IC) package configuration. In some embodiments, the IC package configuration also includes a first package comprising a transformer and a mold material enclosing the transformer to form a first package body. In some embodiments, the IC package configuration also includes a first package comprising a first lead set to permit electrical connection to the transformer. In some embodiments, the IC package configuration also includes a second package comprising a lead frame, with two or more semiconductor die supported by the lead frame, and a mold material enclosing the two or more semiconductor die to form a second package body. In some embodiments, the IC package configuration also includes a lead frame comprising a second lead set to permit electrical connection to the two or more semiconductor die, wherein one or more leads of the first lead set is indirectly electrically connected to one or more leads of the second lead set on a substrate, and wherein the first package and the second package are mechanically coupled together.

### DESCRIPTION OF THE DRAWINGS

The manner and process of making and using the disclosed embodiments may be appreciated by reference to the figures of the accompanying drawings. It should be appreciated that the components and structures illustrated in the figures are not necessarily to scale, emphasis instead being placed upon illustrating the principals of the concepts described herein. Like reference numerals designate corresponding parts throughout the different views. Furthermore, embodiments are illustrated by way of example and not limitation in the figures, in which:
FIG. 1 is a perspective view of an integrated circuit (IC) package configuration with a first package disposed on a second package, in accordance with the present disclosure;
FIG. 1A is a side view of the IC package configuration of FIG. 1;
FIG. 1B is a top view of the IC package configuration of FIG. 1;
FIG. 1C is a side view of various illustrations of formed lead configurations;
FIG. 2 is a side view of the IC package configuration of FIG. 1 with an electrically conductive material positioned on leads of the second package, in accordance with the present disclosure;
FIG. 3 is a perspective view of another example IC package configuration with a first package disposed on a second package, in accordance with the present disclosure;
FIG. 3A is a side view of the IC package configuration of FIG. 3;
FIG. 3B is a top view of another example IC package configuration illustrating a different lead arrangement, in accordance with the present disclosure;
FIG. 4 is a side view of another example IC package configuration with the second package disposed on the first package, in accordance with the present disclosure;
FIG. 5 is a side view of another example IC package configuration with the first package disposed on the second package with optional pillars, in accordance with the present disclosure;
FIG. 6 is a side view of another example IC package configuration with the first package disposed on the second package with optional shaped leads formed in a U-shape, in accordance with the present disclosure;
FIG. 7 is a side view of another example IC package configuration with the first package disposed on the second package with optional shaped leads formed in an S-shape, in accordance with the present disclosure;
FIG. 8 is a partially transparent side view of another example IC package configuration with the second package partially embedded within the first package, in accordance with the present disclosure;
FIG. 8A is a perspective view of the package configuration of FIG. 8 illustrating a castellated package edge, in accordance with the present disclosure;
FIG. 9 is a side view of another IC package configuration with the second package almost entirely embedded within the first package, in accordance with the present disclosure; and
FIG. 10 is a side view of another IC package configuration with leads of the first package making direct mechanical and electrical contact with leads of the second package, in accordance with the present disclosure.

### DETAILED DESCRIPTION

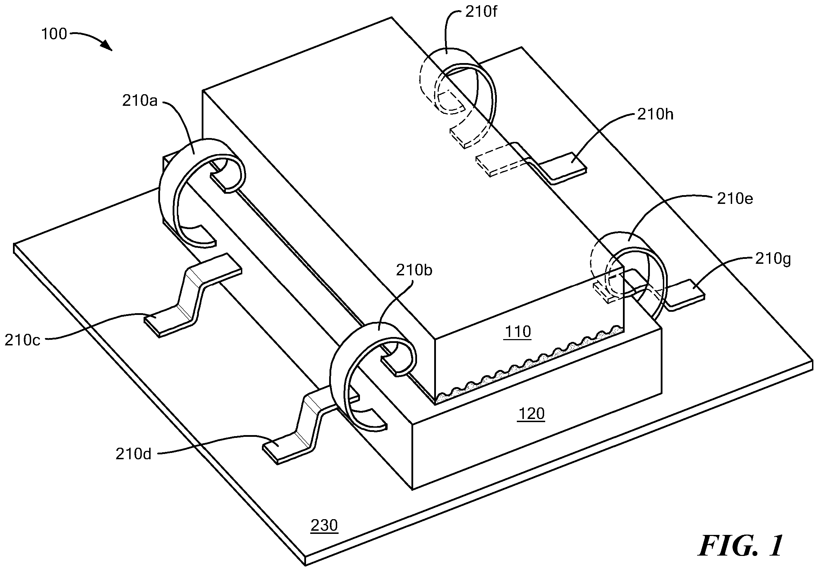

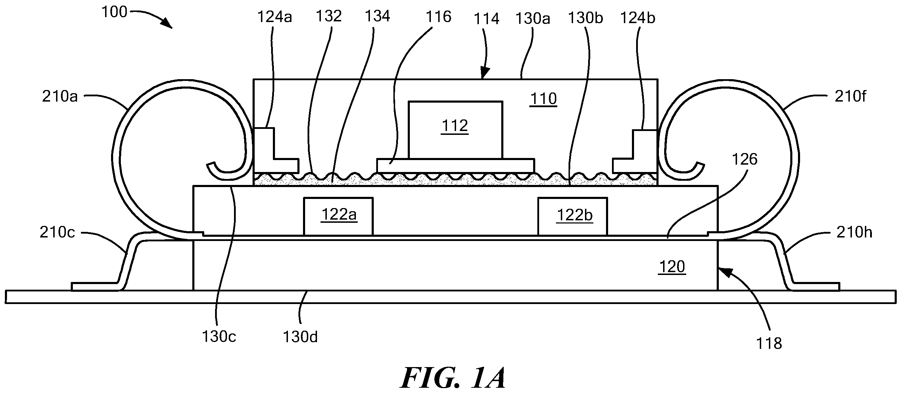

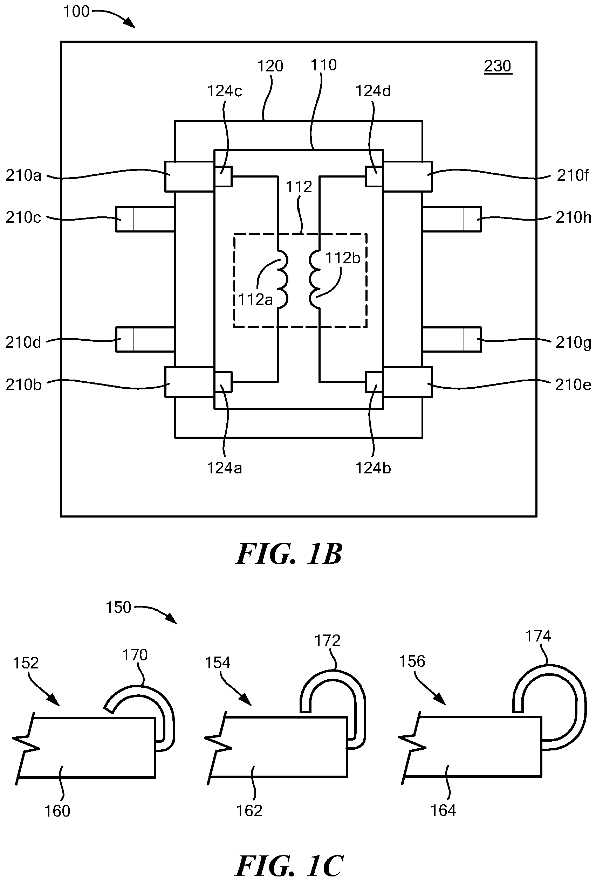

Referring to FIGs. 1, 1A, and 1B, a voltage isolated integrated circuit (IC) package configuration 100 includes a first package 110 and a second package 120 mechanically coupled together. The package configuration 100 can be mounted on a printed circuit board (PCB), lang grid array (LGA), or a ceramic, glass, or other suitable substrate 230 for use in an application system.

The first package 110 includes a first lead set of leads 124a, 124b, 124c, 124d to permit electrical connection to components within the first package 110. The second package 120 includes a second lead set of leads 210a, 210b, 210c, 210d, 210e, 210f, 210g, 210h to permit electrical connection to components within the second package 120. A subset of the second lead set including leads 210a, 210b, 210e, 210f is configured for direct electrical connection with leads of the first lead set 124a, 124b, 124c, 124d and another subset of the second lead set including leads 210c, 210d, 210g, 210h is configured for direct electrical connection to the substrate 230.

It will be appreciated by those of ordinary skill in the art that although the first and second lead sets 124a-124d, 210a-210h are shown with four leads and eight leads, respectively, other numbers of leads are possible including more or fewer leads. Further, although the first lead set 124a-124d and the second lead set 210a-210h extend from the respective packages 110, 120 only from opposite parallel package sides, in some embodiments, one or more leads of one or both lead sets can extend from a package side that is orthogonal with respect to the illustrated sides from which they extend.

In embodiments, the first package 110 contains a transformer 112 and a mold material 114 that encloses the transformer to form the body of the first package 110. The mold material 114 may be a compliant material. A compliant material is one that is soft or less rigid, so it is able to absorb vibration, for example as may result from the operation of the transformer 112.

A mold material 118 is used to form the body of the second package 120, the mold material 118 may be the same as or different than the mold material 114.

Mold materials 114, 118 can be provided with various process techniques, such as transfer molding, potting, or injection molding. Various materials can be used for the mold materials 114, 118, including, but not limited to silicone, epoxy, or a plastic material.

The first package 110 includes a lead frame 116 to support the transformer 112 and provide the first lead set 124a, 124b, 124c, 124d. Alternatively, the first package 110 can include other types of structures to support the transformer and provide leads 124a, 124b, 124c, 124d. Example leads of the first lead set 124a, 124b, 124c, 124d can be of a QFN (Quad-Flat No-leads), or DFN (Dual-Flat No-Leads) type, such that the leads include conductive pads exposed from side and bottom surfaces of the package 110.

The first lead set 124a, 124b, 124c, 124d permits electrical connection to the transformer 112. For example, leads 124a, 124c can be coupled to a first winding, or coil 112a of transformer 112 and leads 124b, 124d can be coupled to a second winding, or coil 112b of transformer 112 that is magnetically coupled to and electrically isolated from the first winding.

The first package 110 has a top surface 130a and a bottom surface 130b. The second package 120 has a top surface 130c and a bottom surface 130d. The bottom surface 130b of the first package 110 can contact the top surface 130c of the second package 120. A non-conductive adhesive 134 may be disposed between the bottom surface 130b of the first package 110 and the top surface 130c of the second package 120 to further enhance mechanical coupling of the packages. The non-conductive adhesive 134 may be a polymer or an epoxy. The non-conductive adhesive 134 may be printed, dispensed, or otherwise applied.

The mold material 114 forming the body of the first package 110 may have a textured area 132 along the bottom surface 130b of the first package 110. The textured area 132 is configured to increase the surface area of the bottom surface 130b. Textured area 132 can facilitate meeting creepage requirements by increasing the surface area of the mold material between leads 124a, 124c as may be primary leads and leads 124b, 124d as may be secondary leads, for example. The textured area 132 may form a ripple or other configuration. The non-conductive adhesive 134 may fill space between the textured area 132 of the bottom surface 130b of the first package 110 and the top surface 130c of the second package 120.

In embodiments, the second package 120 includes a lead frame 126 that supports two or more semiconductor dies 122a, 122b and mold material 118 encloses the semiconductor dies 122a, 122b and a portion of the lead frame 126 to form the body of the second package 120. The lead frame 126 may be a single layer material such as copper or may be a multiple layer substrate in the form of a molded interconnect substrate (MIS). The MIS may include multiple layers of copper with insulation between the layers of copper. The lead frame 126 provides the second lead set including leads 210a, 210b, 210c, 210d, 210e, 210f, 210g, 210h.

The first die 122a and the second die 122b can be coupled to lead frame 126 by various mounting methodologies including, but not limited to the use of wire bonds to plated areas on the lead frame in a so-called die up orientation or conductive bumps or pillars to plated areas of the lead frame in a so-called flip-chip orientation. Lead-on-chip configurations are also possible. The dies 122a, 122b can support various processing circuitry to process signals sought to be isolated by transformer 112. Additional circuitry beyond that supported by dies 122a, 122b can be included in the second package 120 in the form of one or more discrete components, such as a capacitor.

According to an aspect of the disclosure, at least two leads, and here four leads 210a, 210b, 210e, 210f, of the second lead set 210a - 210h, are formed to extend toward the body of the first package 110. The formed shape along with the dimensions and material properties of leads 210a, 210b, 210e, 210f can impart a spring-like quality to the formed leads, thereby permitting some movement or recoil to allow the formed leads to maintain or return to their position and shape when moved. A formed lead may be curled, a bent, or otherwise shaped. For example, such leads can form a circular shape, semicircular shape, an oblong shape, a c-shape, j-bend, or a j-shape.

The first package 110 may be press fit onto the formed leads 210a, 210b, 210e, 210f of the second lead set. The restorative force of the formed leads 210a, 210b, 210e, 210f serves to secure the first package 110 to the second package 120. Once pushed into place in this manner, the formed leads 210a, 210b, 210e, 210f contact respective leads of the first lead set. In particular, formed lead 210a is in direct contact with lead 124c, formed lead 210b is in direct contact with lead 124a, formed lead 210e is in direct contact with lead 124b, and formed lead 210f is in direct contact with lead 124d, as shown. By "direct electrical connection" it is meant that direct physical contact provides an electrical connection between the leads of the first lead set 124a, 124b, 124c, 124d and the formed leads of the second lead set 210b, 210e, 210a, 210f, respectively, as shown.

Referring also to FIG. 1B, a top diagrammatical view of the voltage isolated integrated circuit (IC) package configuration 100 illustrates the first package 110 press fit into the formed leads 210a, 210d, 210e, 210f of the second lead set of the second package and further illustrates the leads 210c, 210d, 210f, 210g of the second lead set coupled to the substrate 230. The subset of the second lead set including leads 210c, 210d, 210f, 210g that are configured for electrical connection to the substrate 230 can be bent for surface mount attachment as shown.

Within the first package 110, the transformer 112 is shown diagrammatically as including winding or coil 112a as may be a primary winding and winding or coil 112b as may be a secondary winding that is magnetically coupled to the first winding but electrically isolated with respect to the first winding. The transformer 112 can take various forms and can include a core (not shown), e.g., a soft ferromagnetic core. The transformer 112 may comprise an air core transformer, which may be used when higher frequencies are involved.

According to an aspect of the disclosure, package configuration 100 can implement a diagonalized lead arrangement as is described further in connection with a co-pending U.S. Patent Application No. 18/307,921 entitled "High Voltage Integrated Circuit Packages with Diagonalized Lead". In a diagonalized lead arrangement, electrical connections are confined to diagonal areas or corners of the package 110 in order to thereby increase the creepage dimension. In an example of one such arrangement, leads 124a, 124c can be more closely positioned relative to each other and near a corner of the package 110 (e.g., near the illustrated position of lead 124a) and leads 124b, 124d can be more closely positioned relative to each other and near a corner of the package that is diagonal with respect to the location of leads 124a, 124c (e.g., near the illustrated position of leads 124d).

Referring to FIG. 1C, an illustration 500 of various formed leads includes various formed lead configurations 152, 154, 156. The formed lead configurations 152, 154, 156 include a formed lead 170, 172, 174, which may be similar to the leads 210a, 210b, 210e, 210f that are formed to extend toward the body of the first package 110 of FIG. 1, extending from a package 160, 162, 164 to form various j-bends.

A first formed lead configuration 152 includes a first package 160. A first formed lead 170 extends out from the first package 160 and is formed such that the end of the first formed lead 170 extends out and back towards the first package 160. The first formed lead 170 forms a j-bend, such as a semicircular shape or a c-shape.

A second formed lead configuration 154 includes a second package 162. A second formed lead 172 extends out from the second package 162 and is formed such that the end of the second formed lead 172 extends out and back towards the second package 162. The second formed lead 172 forms a j-bend, such as a j-shape or an oblong shape.

A third formed lead configuration 156 includes a third package 164. A third formed lead 174 extends out from the third package 164 and is formed such that the end of the third formed lead 174 extends out and back towards the third package 164. The third formed lead 174 forms a j-bend, such as a circular shape.

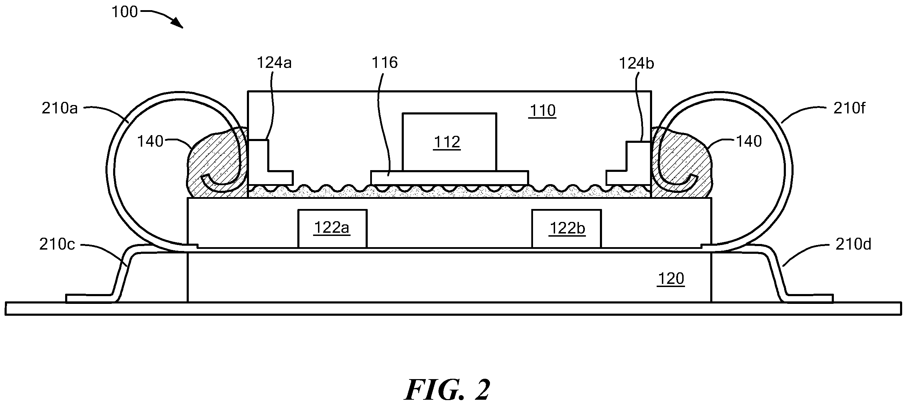

Referring also to FIG. 2, the package configuration 100 is shown to include an additional feature in the form of electrically conductive material 140 disposed on the formed leads 210a, 210b, 210e, 210f. The electrically conductive material 140 can enhance the electrical connection between the formed leads 210a, 210b, 210e, 210f and the first lead set 124a-124d. The electrically conductive material 140 may be used to further align the formed leads 210a, 210b, 210e, 210f of the second lead set with the first lead set 124a-124d. Additional features such as keying features may be utilized to more intentionally align the formed leads 210a, 210b, 210e, 210f of the second lead set with the first lead set 124a-124d. Suitable materials for the electrically conductive material 140 include, but are not limited to conductive epoxy or solder, such as eutectic tin lead, a low stress non-conductive epoxy, or silicone. The electrically conductive material 140 may be disposed through a jetting system or a needle.

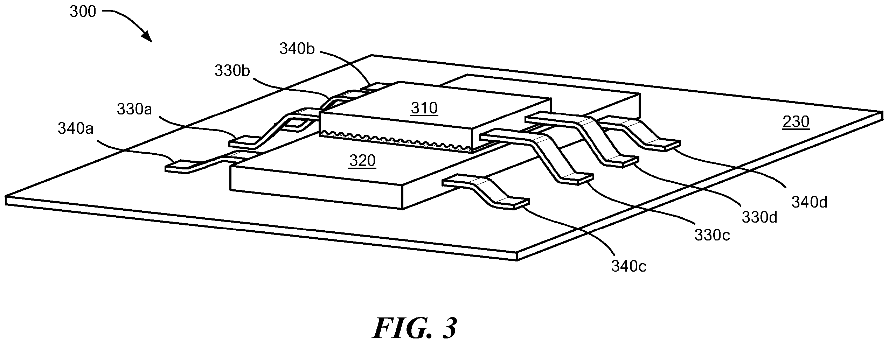

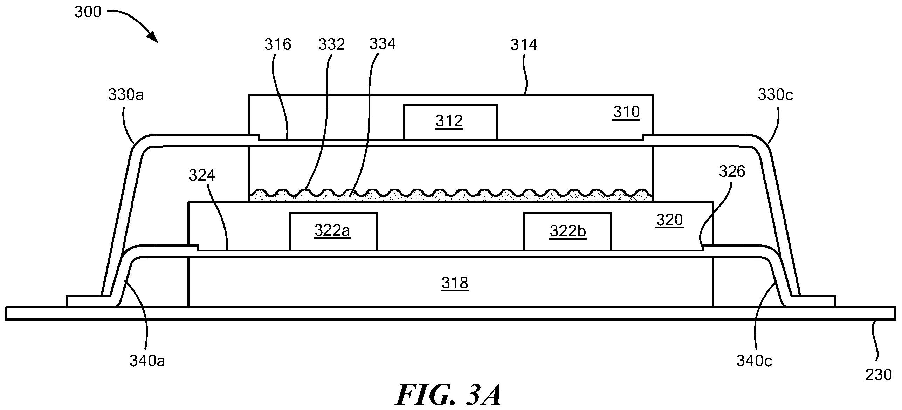

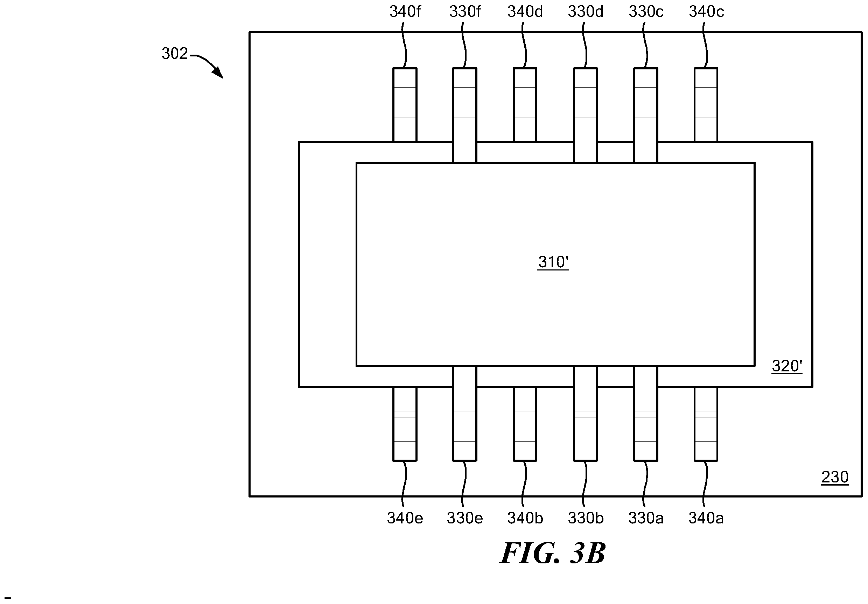

Referring to FIGS. 3 and 3A, an alternative package configuration 300 includes a first package 310 and a second package 320 mechanically coupled together with the first package 310 positioned on top of the second package 320 and the second package being disposed on substrate 230. First package 310 can be similar to package 110 and thus, can include a transformer 312 (like transformer 112) supported by a lead frame 316 (like lead frame 116) and a mold material 314 (like mold material 114) that encloses the transformer 312 to form the body of the first package 310. Lead frame 316 provides a first lead set of leads 330a, 330b, 330c, 330d to permit electrical connection to components within the first package 310.

As contrasted to the package configuration 100, in alternative package configuration 300, the first lead set of leads 330a, 330b, 330c, 330d are configured for electrical connection to the substrate 230. For example, the first lead set of leads 330a, 330b, 330c, 330d can extend from the first package 310 and can be bent for surface mount attachment to substrate 230, as shown.

Second package 320 can be similar to package 120 and thus, can include a lead frame 326 (like lead frame 126) that supports two or more semiconductor dies 322a, 322b (like dies 122a, 122b) and a mold material 318 (like mold material 118) encloses the semiconductor dies 322a, 322b and a portion of the lead frame 326 to form the body of the second package 320. Lead frame 326 provides a second lead set of leads 340a, 340b, 340c, 340d to permit electrical connection to components within the second package 320. The second lead set of leads 340a, 340b, 340c, 340d are configured for electrical connection to the substrate 230. For example, the second lead set of leads 340a, 340b, 340c, 340d can extend from the second package 320 and can be bent for direct connection with the substrate 230, as shown.

The first package 310 and the second package 320 are indirectly electrically connected to each other by conductive traces or other conductive mechanisms of the substrate 230. By "indirect electrical connection" it is meant that leads of the first lead set 330a, 330b, 330c, 330d do not make direct physical contact with the leads of the second lead set 340a, 340b, 340c, 340d, respectively, but rather, an intermediate mechanism (e.g., conductive traces on the substrate 230) is provided to electrically connect the two lead sets.

Leads of the first and second lead sets may be different lengths. For example, leads of the first lead set 330a, 330b, 330c, 330d are longer compared to leads of the second lead set 340a, 340b, 340c, 340d since the first package 310 is further from the substrate 230 than the second package 320.

FIG. 3B is a top view of another alternative package configuration 302 to illustrate that a first package 310' that may be similar to package 310 and a second package 320' that may be similar to package 320 can include more than four leads in their respective lead sets. For example, first package 310' has six leads 330a-f, and second package 320' has six leads 340a-f. The first package 310' and/or the second package 320' may have more than four leads for a multi-tap core, allowing multiple voltages to be generated.

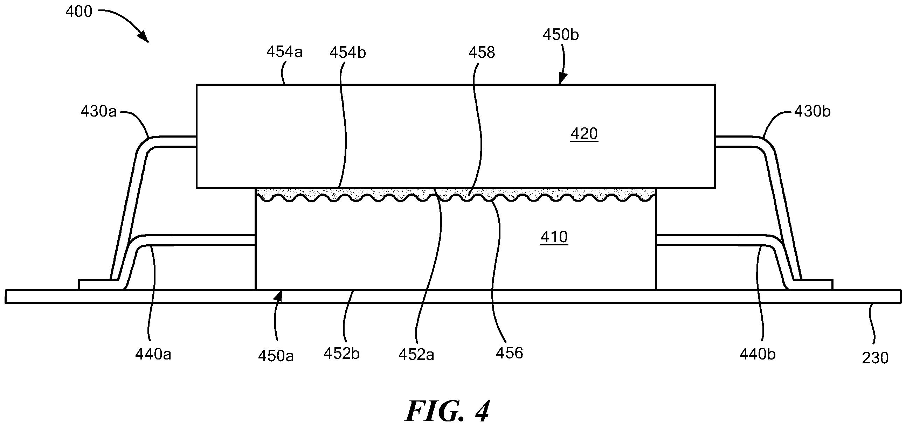

Referring now to FIG. 4, according to an aspect of the disclosure, an alternative package configuration 400 includes a second package 420 (that may be similar to package 120 and thus may include semiconductor dies) positioned atop a first package 410 (that may be similar to package 110 and thus may include a transformer). The first package 410 is mounted on the substrate 230. Leads of a first lead set with which electrical connection is made to components of the first package 410 can include leads 440a, 440b and leads of a second lead set with which electrical connection is made to components of the second package 420 can include leads 430a, 430b. Similar to FIG. 3, indirect electrical connection between leads of the first and second lead set can be made on the substrate (e.g., through conductive traces). Direct electrical connection between the first and second lead sets is also possible while still having the first transformer package 410 below the first semiconductor die package 420, such as in the press-fit manner of FIG. 1.

The first package 410 has a top surface 452a and a bottom surface 452b and a mold material 450a that forms the body of the first package 410. The second package 420 has a top surface 454a and a bottom surface 454b. The mold material 450a forming the body of the first package 410 may have a textured area 456 along the top surface 452a. Textured area 456 can facilitate meeting creepage requirements by increasing the surface area of the mold material between primary and secondary leads. A non-conductive adhesive 458 that may be similar to non-conductive adhesive 134 may be disposed between the first package 410 and the second package 420.

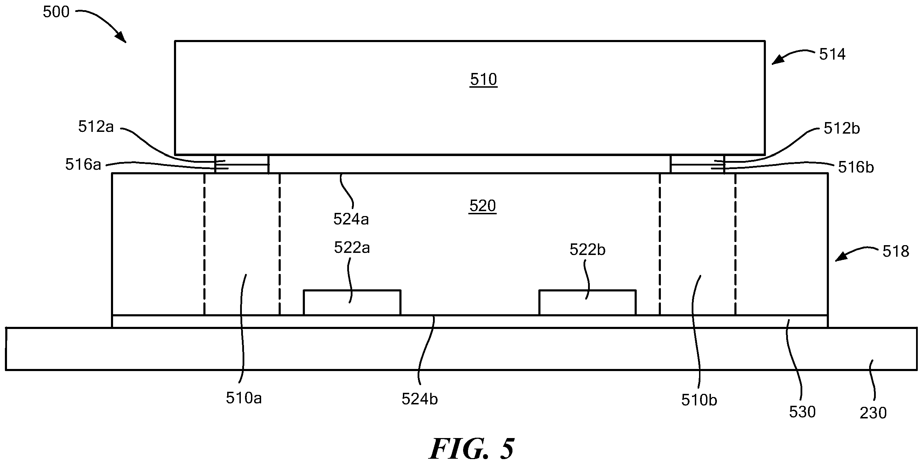

Referring now to FIG. 5, according to an aspect of the disclosure, an alternative package configuration 500 includes a first package 510 positioned atop a second package 520. The first package 510 can be the same as or similar to package 110 and thus, can include a transformer and a first mold material 514 that encloses the transformer to form a first package body.

The second package 520 can include a lead frame 530 that supports two or more semiconductor dies 522a, 522b (that can be the same as or similar to dies 122a, 122b) and a second mold material 518, that can enclose the lead frame 530 and dies 522a, 522b to form a second package body. The second package 520 can include pillars 510a, 510b that are configured to electrically couple the dies 522a, 522b to the first package 510. Suitable materials for the pillars 510a, 510b include, but are not limited to copper, aluminum, or brass.

Various techniques are possible for forming the second package 520 with pillars 510a, 510b. For example, pillars 510a, 510b can be preformed and can be positioned on the lead frame 530 using a pick and place tool and soldered to the lead frame 530 to achieve electrical connection. Mold material 518 can enclose the lead frame 530, pillars 510a, 510b, and the dies 522a, 522b.

In an alternative fabrication process, pillars 510a, 510b can be formed by plating apertures in the second package body. More particularly, once the dies 522a, 522b are attached to the lead frame 530, the second package body can be formed by insert molding. Through insert molding, a cavity is formed including features such as apertures. Apertures are formed from a bottom surface 524b of the package body to a top surface 524a of the package body. The dies 522a, 522b may be electrically connected to the pillars 510a, 510b through plating or through plated balls that are mechanically attached using solder. The apertures can be plated in order to form the conductive pillars 510a, 510b that extend from the lead frame 530 to the top surface 524a of the second package. The dimensions of pillars 510a, 510b may be determined based on the application, specifically the mechanical requirements (robustness, clearances, tolerances, etc.), as well as the electrical and thermal resistance.

After the pillars 510a, 510b and second mold material 518 are disposed, the second mold material 518 is then processed to expose the top of the pillars 510a, 510b in order to enable the connection with the first package 510. Laser ablation may be used to expose the top of the pillars 510a, 510b. Alternatively or additionally, polishing may be used to expose the top of the pillars 510a, 510b.

Inter-package connections 512a, 512b between the pillars 510a, 510b and first package 510 can take various forms. The connections 512a, 512b may be between about 0.5 mm (+/- 0.1 mm) and about 1.0 mm (+/- 0.1 mm). A first connection 512a is in contact with the first pillar 510a and the first package 510. A second connection 512b is in contact with the second pillar 510b and the first package 510. The connections 512a, 512b may be formed by plating a material, such as copper, onto the pillars 510a, 510b. The connections 512a, 512b may be formed by soldering a material, such as a tin-lead (SnPb) mixture, onto the pillars 510a, 510b, other solder material may be used. The width of connections 512a, 512b may be the same as or different than the width of the pillars 510a, 510b.

The connections 512a, 512b may further include diffusion barriers 516a, 516b positioned between the pillars 510a, 510b and connections 512a, 512b. A first diffusion barrier 516a is in contact with the first pillar 510a and the first connection 512a. A second diffusion barrier 516b is in contact with the second pillar 510b and the second connection 512b. The width of the diffusion barriers 516a, 516b may be the same as or different than the width of the pillars 510a, 510b or the width of the connections 512a, 512b. Various materials can be used to form the diffusion barrier including, but not limited to nickel.

It will be appreciated by those of ordinary skill in the art that although the second package 520 is shown with two pillars 510a, 510b, respectively, other numbers of pillars are possible. For example, four pillars may be used with each pillar placed in a corner of the lead frame 530. Further, although the first pillar 510a and the second pillar 510b are positioned on opposing sides of the lead frame 530, they may be positioned closer together or farther apart.

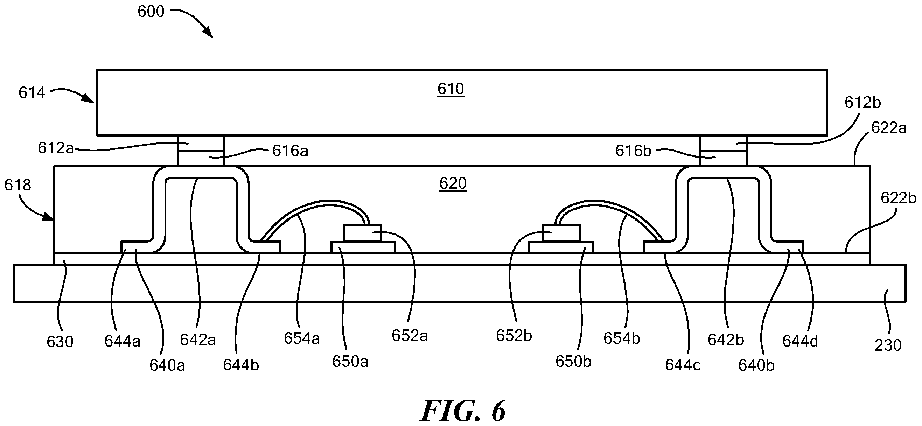

Referring now to FIG. 6, according to an aspect of the disclosure, an alternative package configuration 600 includes shaped leads 640a, 640b within a second package 620 to couple semiconductor die 650a, 650b to a top surface 622a of the second package 620. The first package 610 is positioned atop the second package 620. The first package 610 can be the same as or similar to package 110 and thus, can include a transformer and a first mold material 614 encloses the transformer to form a first package body.

The second package 620 can include a lead frame 630 that supports two or more semiconductor dies 650a, 650b (that can be the same as or similar to dies 122a, 122b) and a second mold material 618 encloses the lead frame 630 and dies 650a, 650b to form a second package body. The shaped leads 640a, 640b may be preformed out of copper. A first semiconductor die 650a is spaced apart from a second semiconductor die 650b, both semiconductor dies 652a, 652b are disposed atop the lead frame 630. A first bond pad 652a of the first semiconductor die 650a is connected to a bottom side 644b of a first shaped lead 640a with a first wire bond 654a. A second bond pad 652b of the second semiconductor die 650b is connected to a bottom side 644c of a second shaped lead 640b with a second wire bond 654b.

Various techniques are possible for forming the second package 620 with shaped leads 640a, 640b. For example, shaped leads 640a, 640b can be preformed and can be positioned on the lead frame 630 using a pick and place tool and soldered to the lead frame 630 to achieve electrical connection. Wire bonds 654a, 654b are coupled between the bond pads 652a, 652b and the shaped leads 640a, 640b. The second mold material 618 can enclose the lead frame 630, shaped leads 640a, 640b, dies 650a, 650b, bond pads 652a, 652b, and wire bonds 654a, 654b.

After the shaped leads 640a, 640b and second mold material 618 are disposed, the second mold material 618 is then processed to expose the top of the shaped leads 640a, 640b, in order to enable the connection with the first package 610. Laser ablation may be used to expose the top of the shaped leads 640a, 640b. Alternatively or additionally, polishing may be used to expose the top of the shaped leads 640a, 640b.

Inter-package connections 612a, 612b between the shaped leads 640a, 640b and first package 610 can take various forms. A first connection 612a is in contact with the first shaped lead 640a and the first package 610. A second connection 612b is in contact with the second shaped lead 640b and the first package 610. The connections 612a, 612b may be formed by plating a material, such as copper, onto the shaped leads 640a, 640b. The connections 612a, 612b may be formed by soldering a material, such as a tin-lead (SnPb) mixture, onto the shaped leads 640a, 640b, other solder material may be used. The width of connections 612a, 612b may be the same as or different than the width of the shaped leads 640a, 640b.

The connections 612a, 612b may further include diffusion barriers 616a, 616b between the shaped leads 640a, 640b and connections 612a, 612b. A first diffusion barrier 616a is in contact with the first shaped lead 640a and the first connection 612a. A second diffusion barrier 616b is in contact with the second shaped lead 640b and the second connection 612b. The width of the diffusion barriers 616a, 616b may be the same as or different than the width of the shaped leads 640a, 640b or the width of the connections 612a, 612b.

It will be appreciated by those of ordinary skill in the art that although the second package 620 is shown with two shaped leads 640a, 640b, respectively, other numbers of leads are possible. For example, four leads may be used with each pillar placed in a corner of the lead frame 630. Further, although the first and the second shaped leads 640a, 640b are positioned on opposing sides of the lead frame 630, they may be positioned closer together or farther apart.

The shaped leads may form a curl, a bend or a shape, for example the shaped leads may form a U-shape, as shown. The U-shape extends from the top surface 622a to the bottom surface 622b of the second package 620. A top side 642a, 642b of the U-shape is positioned on a top surface 622a of the second package 620. A bottom side 644a, 644b, 644c, 644d of the U-shape forms two sections that are in contact with the lead frame 630 and the wire bonds 654a, 654b.

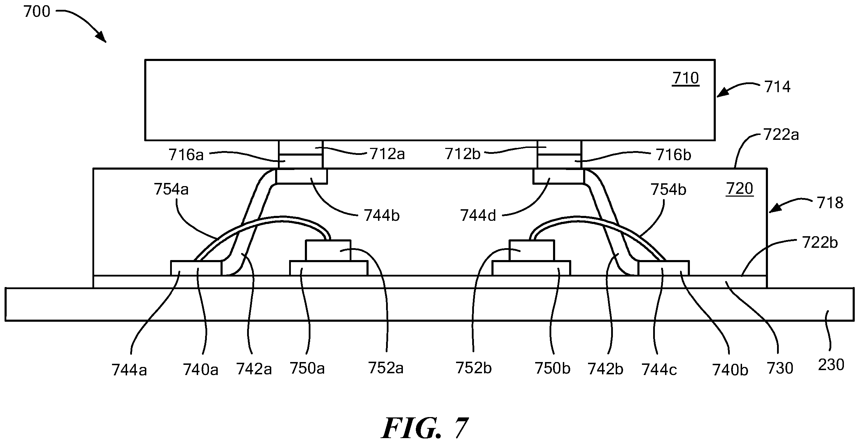

Referring now to FIG. 7, according to an aspect of the disclosure, an alternative package configuration 700 includes shaped leads 740a, 740b within a second package 720 to couple semiconductor dies 750a, 750b to a top surface 722a of the second package 720. The first package 710 is positioned atop the second package 720. The first package 710 can be the same as or similar to package 110 and thus, can include a transformer and a first mold material 714 that encloses the transformer to form a first package body.

The second package 720 can include a lead frame 730 that supports two or more semiconductor dies 750a, 750b (that can be the same as or similar to dies 122a, 122b) and a second mold material 718 encloses the lead frame 730 and dies 750a, 750b to form a second package body. The shaped leads 740a, 740b may be preformed out of copper. A first semiconductor die 750a is spaced apart from a second semiconductor die 750b, both semiconductor dies 750a, 750b are disposed atop the lead frame 730. A first bond pad 752a of the first semiconductor die 750a is connected to a bottom side 744a of a first shaped lead 740a with a first wire bond 754a. A second bond pad 752b of the second semiconductor die 750b is connected to a bottom side 744b of a second shaped lead 740b with a second wire bond 754b.

Various techniques are possible for forming the second package 720 with shaped leads 740a, 740b. For example, shaped leads 740a, 740b can be preformed and can be positioned on the lead frame 730 using a pick and place tool and soldered to the lead frame 730 to achieve electrical connection. Wire bonds 754a, 754b are coupled between the bond pads 752a, 752b and the shaped leads 740a, 740b. The second mold material 718 can enclose the lead frame 730, shaped leads 740a, 740b, dies 750a, 750b, bond pads 752a, 752b, and wire bonds 754a, 754b.

After the shaped leads 740a, 740b and mold material 718 are disposed, the mold material 718 is then processed to expose the top of the shaped leads 740a, 740b, in order to enable the connection with the first package 710. Laser ablation may be used to expose the top of the shaped leads 740a, 740b. Alternatively or additionally, polishing may be used to expose the top of the shaped leads 740a, 740b.

Inter-package connections 712a, 712b between the shaped leads 740a, 740b and first package 710 can take various forms. A first connection 712a is in contact with the first shaped lead 740a and the first package 710. A second connection 712b is in contact with the second shaped lead 740b and the first package 710. The connections 712a, 712b may be formed by plating a material, such as copper, onto the shaped leads 740a, 740b. The connections 712a, 712b may be formed by soldering a material, such as a tin-lead (SnPb) mixture, onto the shaped leads 740a, 740b, other solder material may be used. The width of connections 712a, 712b may be the same as or different than the width of the shaped leads 740a, 740b.

The connections 712a, 712b may further include diffusion barriers 716a, 716b between the shaped leads 710a, 710b and connections 712a, 712b. A first diffusion barrier 716a is in contact with the first shaped lead 740a and the first connection 712a. A second diffusion barrier 716b is in contact with the second shaped lead 740b and the second connection 712b. The width of the diffusion barriers 716a, 716b may be the same as or different than the width of the shaped lead 740a, 740b or the width of the connections 712a, 712b.

It will be appreciated by those of ordinary skill in the art that although the second package 720 is shown with two shaped leads, other numbers of leads are possible. For example, four leads may be used with each pillar placed in a corner of the lead frame 730. Further, although the first and the second shaped leads 740a, 740b are positioned on opposing sides of the lead frame 730, they may be positioned closer together or farther apart.

Shaped leads 740a, 740b can form an S-shape, as shown. The S-shape extends from the top surface 722a to the bottom surface 722b of the second package 720. A top side 744b, 744d of the S-shape is positioned on a top surface 722a of the second package 720 and in contact with a bottom side 744a, 744c through a middle portion 742a, 742b. The bottom side 744a, 744c of the S-shape is in contact with the lead frame 730 and the wire bonds 754a, 754b.

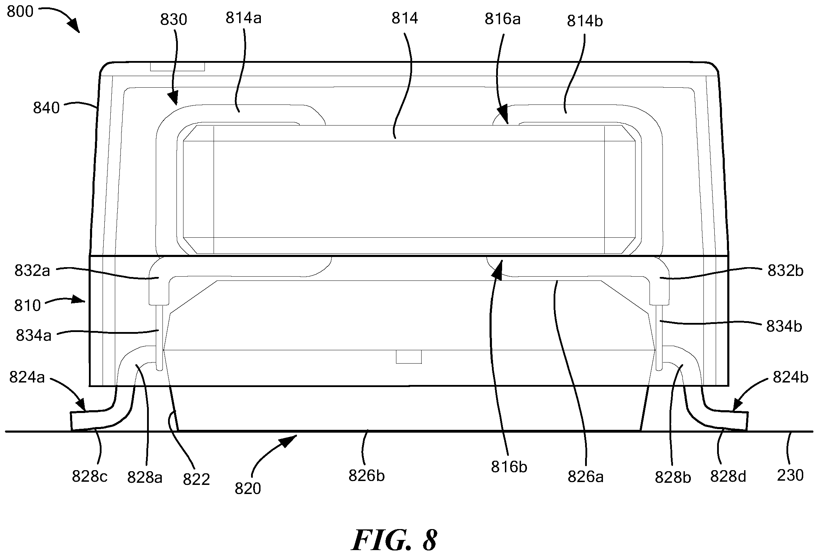

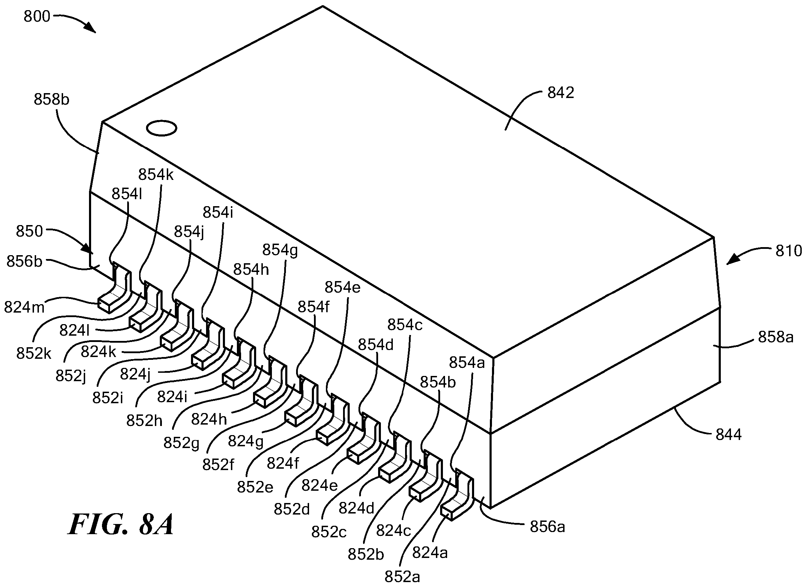

Referring now to FIGs. 8 and 8A, according to an aspect of the disclosure, an alternative package configuration 800 includes a first package 810 and a second package 820 mechanically coupled together. The second package 820 is partially embedded within the first package 810. The package configuration 800 can be mounted on the substrate 230.

First package 810 includes a transformer 830, the transformer 830 may be the same as or similar to the transformer 112. Transformer 830 includes a transformer core 814 and transformer windings or coils 814a, 814b. In embodiments, the first package 810 includes a first lead set 832a, 832b to permit electrical connection to the components inside the first package 810. For example, a first lead 832a can be coupled to a first winding, or coil 814a of transformer 830. A second lead 832b can be coupled to a second winding, or coil 814b of transformer 830 that is magnetically coupled to and electrically isolated from the first coil 814b.

The second package 820 includes a lead frame that supports two or more semiconductor dies and a mold material 822 that encloses the semiconductor dies and a portion of the lead frame to form the body of the second package 820, which lead frame and semiconductor dies may be similar to the lead frame 126 and semiconductor dies 122a, 122b. The lead frame provides a second lead set including leads 824a, 824b, with which electrical connection is made to the semiconductor dies. Leads 824a, 824b extend from the second package 820 on opposite package sides.

The first package 810 is electrically connected to the second package 820. In an embodiment, connections 834a, 834b provide an electrical connection between the second package 820 and the transformer 830. The leads 832a, 832b from the first lead set can be mechanically and electrically connected to leads 824a, 824b from the second lead set with connections 834a, 834b respectively. Connections 834a, 834b can take various forms including, but not limited to conductive loops.

In some embodiments, electrically conductive material, such as the electrically conductive material 140, may be used to enhance electrical connection between the first lead set 832a, 832b and the second lead set 834a, 834b. In some embodiments, the first lead set 832a, 832b may be welded or crimped in order to further connect the first lead set 832a, 832b to the second lead set 834a, 834b, respectively.

The transformer core 814 and windings or coils 814a, 814b define a top surface 816a and a bottom surface 816b. The second package 820 has a top surface 826a and a bottom surface 826b. The bottom surface 816b of the transformer 830 is positioned atop the top surface 826a of the second package 820. The bottom surface 826b of the second package 820 is positioned on or adjacent to the substrate 230. The second lead set 824a, 824b is configured for direct electrical connection to the substrate 230.

The first package 810 includes a mold material 840, which may be similar to the mold material 114, 118 discussed in FIGs. 1, 1A, and 1B. The mold material 840 encloses the transformer 830 and the first lead set 832a, 832b. In embodiments, the first package 810 encloses at least a portion of the second package 820. The first package 810 is disposed over a portion of the second package 820, but does not extend all the way to the bottom surface 826b and in this way the second package 820 can be considered to be partially embedded within the first package 810. An encapsulation fill can be used to fill space between the first package 810 and the second package 820 to secure the second package 820. The encapsulation fill may comprise a relatively soft material, such as an epoxy or silicone. The encapsulation fill may be disposed using a jetting system or potting via a needle. The encapsulation fill may be molded to mold material 840 before it is disposed to the second package 820, the mold material 840 may be applied via a pick and place machine then reflow soldering may be used for the interconnect. The encapsulation fill may be applied after the after the mold material 840 is disposed to the second package 820 with potting via a needle under a vacuum to allow for robust filling.

FIG. 8A is a perspective view of the package configuration 800 illustrating a castellated package edge 850. The first package 810 includes a top surface 842 on an opposing side from a bottom surface 844. The bottom surface 844 is located towards the second lead set 824a, 824c, 824d, 824e, 824f, 824g, 824h, 824i, 824j, 824k, 824l, 824m. Along the bottom surface 844 is a castellated package edge 850. The castellated package edge 850 assists with assembly alignment during the formation of the package configuration. The castellated package edge 850 can enable the second package body to move further into the first package body.

The castellated package edge 850 includes extensions 852a-852k, recesses 854a-854l, and side portions 856a, 856b. The first package 810 includes extensions 852a-852k where the mold material 840 extends out to the bottom surface 844 and recesses 854a-8541 where mold material 840 stops at a distance before the bottom surface creating a cavity. The recesses 854a-854l are disposed such that the second lead set 824a, 824c, 824d, 824e, 824f, 824g, 824h, 824i, 824j, 824k, 824l, 824m is positioned inside recesses 854a-854l and encompassed by the extensions 852a-852k.

Side portions 856a, 856b are formed on either side surface 858a, 858b of the first package 810. To form the side portions 856a, 856b the mold material 840 extends towards the bottom surface 844 and towards a side surface 858a, 858b. A first side portion 856a is formed along the castellated package edge 850 after a first lead 824a to a first side surface 858a. A second side surface 856b is formed along the castellated package edge 850 after a last lead 824m to a second side surface 858b.

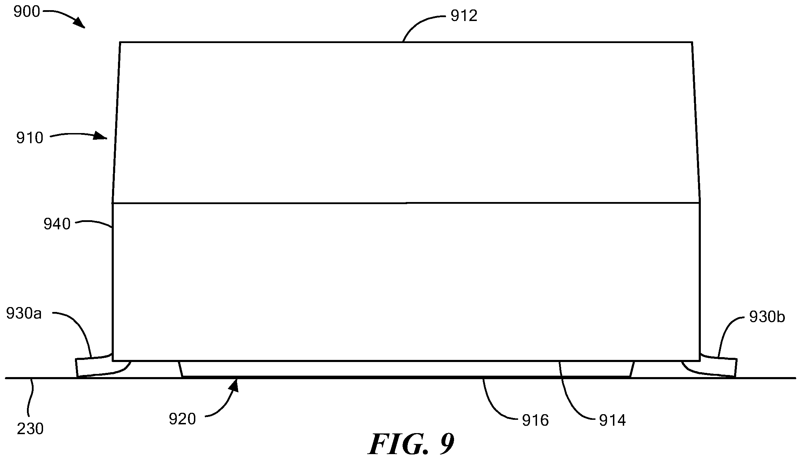

FIG. 9 is a side view of an alternative package configuration 900 with a second package 920 that may be similar to the second package 820 entirely or near entirely embedded within a first package 910 that may be similar to the first package 810. The first package 910 is mechanically and electrically connected to the second package 920.

A set of leads 930a, 930b that may be similar to the second lead set 824a, 824b extends out from the second package 920. The second package 920 has a bottom surface 916 that disposed on or adjacent to a substrate 230. The first package 910 has a top surface 912 and a bottom surface 914.

A mold material 940 forms the body of the first package 910. The first package 910 extends such that the bottom surface 914 of the first package 910 is in line with the bottom surface 916 of the second package 920. In this way, the second package 920 can be considered fully or nearly fully embedded within the first package 910.

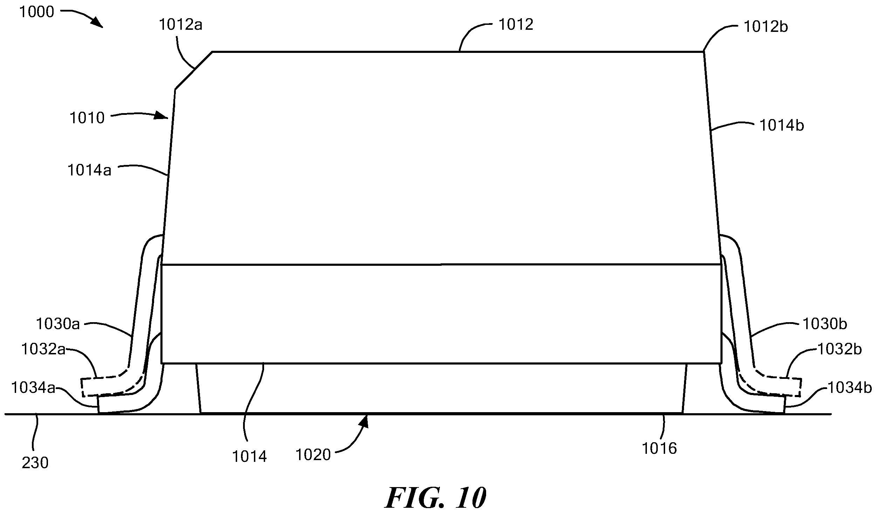

FIG. 10 is a side view of an alternative package configuration 1000 with a first set of leads 1030a, 1030b of a first package 1010 making direct mechanical and electrical contact with a second set of leads 1034a, 1034b of a second package 1020. The second package 1020 that may be similar to the second package 820 is partially embedded in the first package 1010 that may be similar to the first package 810.

The second package 1020 has a bottom surface 1016 that is disposed on or adjacent to a substrate 230. Leads 1034a, 1034b of the second lead set extend from the second package 1020 and may be similar to the second lead set 824a, 824b. Leads 1030a, 1030b extend from the first package 1010 and may be similar to the first lead set 832a, 832b.

The leads 1030a, 1030b may be shorter as illustrated by sold lines 1030a, 1030b or may be longer as illustrated by dotted lines 1032a, 1032b. The shorter leads 1030a, 1030b may be used to form a direct mechanical and electrical contact with the leads 1034a, 1034b from the second lead set with lead 1030a mechanically and electrically connected to a first lead 1034a and lead 1030b mechanically and electrically connected to a second lead 1034b.

In embodiments, the leads 1034a, 1034b from the second lead set and the longer leads 1032a, 1032b may be configured for indirect electrical connection. A first longer lead 1032a extends out from the first package 1010 towards the first lead 1034a, both extending towards the substrate 230. A second longer lead 1032b extends out from the first package 1010 towards the second lead 1034b, both extending towards the substrate 230. The longer leads 1032a, 1032b and the lead 1034a, 1034b may be in electrical contact by conductive traces or other conductive mechanisms of the substrate 230.

An electrically conductive material that may be similar to electrically conductive material 140 may be disposed on the leads 1030a, 1030b, 1032a, 1032b, 1034a, 1034b to enhance the electrical connection. The first package 1010 has a top surface 1012 and a bottom surface 1014. The top surface 1012 can be angled in some embodiments.

Although reference is made herein to particular materials, it is appreciated that other materials having similar functional and/or structural properties may be substituted where appropriate, and that a person having ordinary skill in the art would understand how to select such materials and incorporate them into embodiments of the concepts, techniques, and structures set forth herein without deviating from the scope of those teachings.

Various embodiments of the concepts, systems, devices, structures and techniques sought to be protected are described herein with reference to the related drawings. Alternative embodiments can be devised without departing from the scope of the concepts, systems, devices, structures and techniques described herein. It is noted that various connections and positional relationships (e.g., over, below, adjacent, etc.) are set forth between elements in the following description and in the drawings. These connections and/or positional relationships, unless specified otherwise, can be direct or indirect, and the described concepts, systems, devices, structures and techniques are not intended to be limiting in this respect. Accordingly, a coupling of entities can refer to either a direct or an indirect coupling, and a positional relationship between entities can be a direct or indirect positional relationship.

As an example of an indirect positional relationship, references in the present description to forming layer "A" over layer "B" include situations in which one or more intermediate layers (e.g., layer "C") is between layer "A" and layer "B" as long as the relevant characteristics and functionalities of layer "A" and layer "B" are not substantially changed by the intermediate layer(s).The following definitions and abbreviations are to be used for the interpretation of the claims and the specification. As used herein, the terms "comprises," "comprising, "includes," "including," "has," "having," "contains" or "containing," or any other variation thereof, are intended to cover a non-exclusive inclusion. For example, a composition, a mixture, process, method, article, or apparatus that comprises a list of elements is not necessarily limited to only those elements but can include other elements not expressly listed or inherent to such composition, mixture, process, method, article, or apparatus.

Additionally, the term "exemplary" is used herein to mean "serving as an example, instance, or illustration. Any embodiment or design described herein as "exemplary" is not necessarily to be construed as preferred or advantageous over other embodiments or designs. The term "one or more" is understood to include any integer number greater than or equal to one, i.e. one, two, three, four, etc. The terms "a plurality" are understood to include any integer number greater than or equal to two, i.e. two, three, four, five, etc. The term "connection" can include an indirect "connection" and a direct "connection."

References in the specification to "one embodiment, "an embodiment," "an example embodiment," etc., indicate that the embodiment described can include a particular feature, structure, or characteristic, but every embodiment can include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

For purposes of the description hereinafter, the terms "upper," "lower," "right," "left," "vertical," "horizontal, "top," "bottom," and derivatives thereof shall relate to the described structures and methods, as oriented in the drawing figures. The terms "overlying," "atop," "on top, "positioned on" or "positioned atop" mean that a first element, such as a first structure, is present on a second element, such as a second structure, where intervening elements such as an interface structure can be present between the first element and the second element. The term "direct contact" means that a first element, such as a first structure, and a second element, such as a second structure, are connected without any intermediary elements.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

The terms "approximately" and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value. The term "substantially equal" may be used to refer to values that are within ±20% of one another in some embodiments, within ±10% of one another in some embodiments, within ±5% of one another in some embodiments, and yet within ±2% of one another in some embodiments.

The term "substantially" may be used to refer to values that are within ±20% of a comparative measure in some embodiments, within ±10% in some embodiments, within ±5% in some embodiments, and yet within ±2% in some embodiments. For example, a first direction that is "substantially" perpendicular to a second direction may refer to a first direction that is within ±20% of making a 90° angle with the second direction in some embodiments, within ±10% of making a 90° angle with the second direction in some embodiments, within ±5% of making a 90° angle with the second direction in some embodiments, and yet within ±2% of making a 90° angle with the second direction in some embodiments.

It is to be understood that the disclosed subject matter is not limited in its application to the details of construction and to the arrangements of the components set forth in the following description or illustrated in the drawings. The disclosed subject matter is capable of other embodiments and of being practiced and carried out in various ways. Also, it is to be understood that the phraseology and terminology employed herein are for the purpose of description and should not be regarded as limiting. As such, those skilled in the art will appreciate that the conception, upon which this disclosure is based, may readily be utilized as a basis for the designing of other structures, methods, and systems for carrying out the several purposes of the disclosed subject matter. Therefore, the claims should be regarded as including such equivalent constructions insofar as they do not depart from the spirit and scope of the disclosed subject matter.

Although the disclosed subject matter has been described and illustrated in the foregoing exemplary embodiments, it is understood that the present disclosure has been made only by way of example, and that numerous changes in the details of implementation of the disclosed subject matter may be made without departing from the spirit and scope of the disclosed subject matter.

## Claims

1. A voltage isolated integrated circuit (IC) package configuration comprising:
a first package comprising a transformer and a mold material enclosing the transformer to form a first package body, wherein the first package comprises a first lead set to permit electrical connection to the transformer; and
a second package comprising a lead frame, two or more semiconductor die supported by the lead frame, and a mold material enclosing the two or more semiconductor die to form a second package body, wherein the lead frame comprises a second lead set to permit electrical connection to the two or more semiconductor die, wherein one or more leads of the first lead set is directly electrically connected to one or more leads of the second lead set, and wherein the first package and the second package are mechanically coupled together.

2. The IC package configuration of claim 1, wherein at least two leads of the second lead set protrude from a side of the second package body and are formed towards the first package body.

3. The IC package configuration of claim 2, wherein the at least two formed leads are one or more of bent, curled, or shaped.

4. The IC package configuration of claim 2, wherein the first package body is press fit into the at least two formed leads of the second lead set.

5. The IC package configuration of claim 4, further comprising an electrically conductive material positioned on the at least two formed leads of the second lead set, wherein the electrically conductive material is conductive epoxy or solder, non-conductive epoxy, or silicone.

6. The IC package configuration of claim 2, wherein the at least two formed leads of the second lead set are soldered to leads of the first lead set.

7. The IC package configuration of claim 1, wherein the second package body has a top surface adjacent to the first package and a bottom surface configured to be adjacent to a substrate.

8. The IC package configuration of claim 1, wherein the first package body has a top surface adjacent to the second package and a bottom surface configured to be adjacent to a substrate.

9. The IC package configuration of claim 1, wherein the first package and the second package are electrically and mechanically coupled together by conductive connections disposed between the first package body and the second package body.

10. The IC package configuration of claim 1, wherein the second package body has a top surface and a bottom surface, and wherein the second lead set comprises preformed pillars that extend from the bottom surface to the top surface of the second package body.

11. The IC package configuration of claim 10, wherein the preformed pillars are configured to be positioned with a pick and place tool.

12. The IC package configuration of claim 10, wherein the preformed pillars extend from the bottom surface to the top surface of the second package body in an inverted U-shape.

13. The IC package configuration of claim 10, wherein the preformed pillars extend from the bottom surface to the top surface of the second package body in an S-shape.

14. The IC package configuration of claim 1, wherein apertures extend from a top surface to a bottom surface of the second package body and wherein the second package further comprises plating in the apertures to form pillars.

15. The IC package configuration of claim 14, further comprising a diffusion barrier between the pillars and the second package body.

16. The IC package configuration of claim 15, wherein the diffusion barrier is comprised of nickel.

17. The IC package configuration of claim 10, wherein the pillars are comprised of copper, aluminum, or brass.

18. A voltage isolated integrated circuit (IC) package configuration comprising:
a first package comprising a transformer and a mold material enclosing the transformer to form a first package body, wherein the first package comprises a first lead set to permit electrical connection to the transformer; and
a second package comprising a lead frame, with two or more semiconductor die supported by the lead frame, and a mold material enclosing the two or more semiconductor die to form a second package body, wherein the lead frame comprises a second lead set to permit electrical connection to the two or more semiconductor die, wherein one or more leads of the first lead set is indirectly electrically connected to one or more leads of the second lead set on a substrate, and wherein the first package and the second package are mechanically coupled together.

19. The IC package configuration of claim 1 or 18, further comprising a non-conductive adhesive disposed between the first package body and the second package body.

20. The IC package configuration of claim 18, wherein the second package has a top surface and a bottom surface, wherein the top surface is adjacent to the first package, the bottom surface is configured to be electrically coupled to the substrate, and the first set of leads is longer than the second set of leads.

21. The IC package configuration of claim 7 or 20, wherein the first package body has a top surface and a bottom surface, wherein the bottom surface is adjacent to the second package, and wherein the bottom surface comprises a textured area configured to increase an area of the bottom surface.

22. The IC package configuration of claim 18, wherein the first package has a top surface and a bottom surface, wherein the top surface is adjacent to the second package, the bottom surface is configured to be electrically coupled to a substrate, and the second set of leads is longer than the first set of leads.

23. The IC package configuration of claim 8 or 22, wherein the second package body has a top surface and a bottom surface, wherein the bottom surface is adjacent to the first package, and wherein the bottom surface comprises a textured area configured to increase an area of the bottom surface.

24. The IC package configuration of claim 1 or 18, wherein the second package body is embedded within the first package body.

25. The IC package configuration of claim 24, wherein the second package body is partially embedded within the first package body.

26. The IC package configuration of claim 24, wherein the second package body is fully embedded within the first package body.

27. The IC package configuration of claim 1 or 24, wherein the first package body has a top surface and a bottom surface, wherein the bottom surface comprises a castellated package edge.
